# EUROPÄISCHE PATENTSCHRIFT

(11) **EP 4 469 695 B1**
(45) Veröffentlichungstag und Bekanntmachung des Hinweises auf die Patenterteilung: **25.02.2026**
(21) Anmeldenummer: 22830563.7
(22) Anmeldetag: 27.12.2022
(51) Int. Cl.: F16D 66/00, G01P 3/00, H02H 3/00

(54) **ANSTEUERSCHALTUNG FÜR EINEN AKTIVEN DREHZAHLSENSOR**
CONTROL CIRCUIT FOR AN ACTIVE ROTATIONAL SPEED SENSOR
CIRCUIT DE COMMANDE POUR CAPTEUR DE VITESSE DE ROTATION ACTIF

(30) Priorität: 27.01.2022 DE 102022101930
(43) Veröffentlichungstag der Anmeldung: 04.12.2024
(73) Patentinhaber: KNORR-BREMSE Systeme für Nutzfahrzeuge GmbH, 80809 München (DE)
(72) Erfinder: FEUCHT, Thomas, 71299 Wimsheim (DE)
(86) Internationale Anmeldenummer: PCT/EP2022/087886
(87) Internationale Veröffentlichungsnummer: WO 2023/143846

(56) Entgegenhaltungen:
- CN-A- 103 018 473
- KR-B1- 101 024 496
- US-A1- 2007 274 013

## Beschreibung

Die vorliegende Erfindung bezieht sich auf eine Ansteuerschaltung für einen aktiven Drehzahlsensor und insbesondere auf eine Schaltung zur Steuerung, Signalaufbereitung und Überwachung eines aktiven Drehzahlsensors, wozu insbesondere Folgendes zählt: Aktivieren und Deaktivieren und Einstellen einer Versorgungsspannung, Detektion eines Überstromes einschließlich einer automatischen Notabschaltung des Drehzahlsensors.

Aktive Drehzahlsensoren werden in Fahrzeugen eingesetzt, um beispielsweise für ein Antiblockiersystem (ABS) oder für andere Fahrassistenzsysteme eine Drehzahlüberwachung von Rädern durchzuführen, um gezielt Eingriffe zu ermöglichen, falls eine Radgeschwindigkeit nicht einem Sollwert entspricht. Solche Drehzahlsensoren sind dabei erheblichen Umwelteinflüssen ausgesetzt und müssen eine hohe Zuverlässigkeit im Dauerbetrieb aufweisen. Störungen umfassen beispielsweise Kurzschlüsse zur Versorgungsspannung (z.B. Batteriespannung) oder zur Masse. Für diese Drehzahlsensoren ist es außerdem wichtig, den Strom, der in den Drehzahlsensor hinein oder heraus fließt, nicht nur zu überwachen, sondern bei Überschreiten von Grenzwerten rechtzeitig eine Abschaltung durchzuführen. Die gewünschte hohe Zuverlässigkeit kann aber nur sichergestellt werden, wenn Beschädigungen des aktiven Drehzahlsensors durch derartige kritische Zustände (Überstrom, Überspannung etc.) sicher vermieden werden.

Dafür kommen spezifische Ansteuerschaltungen zum Einsatz, die den Drehzahlsensor einerseits mit der nötigen Versorgungsspannung versorgen und andererseits einen Schutz für den Drehzahlsensor und die nachfolgende Elektronik bieten.

Konventionelle Ansteuerschaltungen bieten aber noch nicht das gewünschte Niveau an Zuverlässigkeit, da die mitunter komplexen integrierten Schaltungen viele Quellen von Störungen bieten. Über längere Zeiträume (zum Beispiel mehr als 15 Jahre) sind sie häufig nicht störungsfrei einsetzbar. Im übrigen sind sie aufgrund der Komplexität häufig nicht kostengünstig produzierbar.

Dokument US2007/274013A1 offenbart eine Ansteuerschaltung nach dem Stand der Technik.

Daher besteht ein Bedarf nach Ansteuerschaltungen für aktive Drehzahlsensoren, die eine zuverlässige Überwachung erlauben und eine hohe Zuverlässigkeit während eines langfristigen Betriebes sicherstellen.

Zumindest ein Teil der obengenannten Probleme wird durch die Ansteuerschaltung nach Anspruch 1 und einem Verfahren zum Betreiben der Ansteuerschaltung nach Anspruch 13 gelöst. Die abhängigen Ansprüche beziehen sich auf weitere vorteilhafte Weiterbildungen des Gegenstandes des unabhängigen Anspruchs.

Die vorliegende Erfindung bezieht sich auf eine Ansteuerschaltung für einen aktiven Drehzahlsensor eines Fahrzeuges. Der aktive Drehzahlsensor ist ausgebildet, um eine Drehzahl eines Rades zu erfassen und darauf basierend ein Sensorsignal auszugeben. Die Ansteuerschaltung umfasst eine Überwachungsschaltung, die Folgendes aufweist:
- einen ersten Anschluss und einen zweiten Anschluss zum elektrischen Anschluss des Drehzahlsensors und zum Empfangen des Sensorsignals;
- einen Versorgungsanschluss zum Anschluss an eine Versorgungsspannung und einen Masseanschluss zum Anschluss an eine Masse;
- einen Sensorsignalausgang zum Bereitstellen des Sensorsignals vom aktiven Drehzahlsensor;
- einen ersten Schalter, der ausgebildet ist, um den ersten Anschluss mit dem Versorgungsanschluss zu schalten;
- einen zweiten Schalter, der ausgebildet ist, um den zweiten Anschuss mit dem Masseanschluss zu schalten;
- einen Überstromdetektor, der ausgebildet ist, um einen Überstrom durch den Versorgungsanschluss oder durch den Masseanschluss zu detektieren und auf eine Detektion den ersten Schalter oder den zweiten Schalter zu öffnen; und
- einen Spannungskontroller, der ausgebildet ist, um eine Anpassung einer elektrische Spannung zwischen dem ersten Anschluss und dem Masseanschluss an einen Sollwert zu bewirken.

Die Versorgungsspannung kann die eine Batteriespannung des Fahrzeugs sein oder ein andere vorbestimmte Spannung. Es versteht sich, dass ein Schalten entweder ein Öffnen oder Schließen sein kann bzw. Herstellen oder Unterbrechen einer elektrischen Verbindung zwischen betreffenden Anschlüssen. Der Überstromdetektor kann beispielsweise bei Überstrom durch den Versorgungsanschluss den ersten Schalter öffnen. Der Überstromdetektor kann alternativ oder zusätzlich bei Überstrom zur Masse den zweiten Schalter öffnen. Wenn die kritische Überstromsituation vorbei ist, kann der Schalter durch eine gezielte zeitliche Ansteuerung (z.B. durch einen Mikrokontroller) wieder geschlossen werden. Es versteht sich, dass keine separate Steuereinheit oder eine ähnliche Logik erforderlich ist, um bei kritischen Zuständen die Schalter zu betätigen oder die Spannung nachzuregeln. Dies erfolgt automatisch durch den beispielhaften Überstromdetektor oder den Spannungskontroller.

Optional umfasst das Sensorsignal ein Geschwindigkeitssignal mit (zumindest) einem Puls und ein Informationssignal mit einer Vielzahl von Pulsen, wobei die Pulse des Informationssignals eine Information über den Drehzahlsensor kodieren und eine kleinere Amplitude aufweisen als der (zumindest) eine Puls des Geschwindigkeitssignals. Die Informationen über den Drehzahlsensor können eine Identifikation des Drehzahlsensors umfassen oder einen gegenwärtigen Status (z.B. die Arbeitsbereitschaft) anzeigen. Für die Kodierung kann ein Manchester-Code, eine Pulsbreitenkodierung oder eine andere Kodierung genutzt werden.

Optional umfasst die Ansteuerschaltung eine Ausleseschaltung, die einen Sensorsignaleingang, der mit dem Sensorsignalausgang verbunden ist, einen Geschwindigkeitssignalausgang und einen Informationssignalausgang aufweist. Außerdem kann die Ausleseschaltung einen ersten Signaldetektor aufweisen, der mit dem Sensorsignaleingang verbunden und ausgebildet ist, um das Geschwindigkeitssignal zu detektieren und basierend darauf ein Drehzahlsignal am Geschwindigkeitssignalausgang bereitzustellen. Die Ausleseschaltung kann weiter einen zweiten Signaldetektor aufweisen, der mit dem Sensorsignaleingang verbunden und ausgebildet ist, um das Informationssignal zu detektieren und die kodierten Information über den Drehzahlsensor am Informationssignalausgang bereitzustellen.

Die Ausleseschaltung kann außerdem einen Rückkoppelschalter aufweisen, der ausgebildet ist, auf eine Detektion des Geschwindigkeitssignals durch den ersten Signaldetektor zur Detektion des Informationssignals eine Sensitivität des zweiten Signaldetektor zu ändern. Der Rückkoppelschalter kann hierfür an den ersten Signaldetektor koppeln, um die Auslöseinformation zur Änderung der Sensitivität zu erhalten. Die Sensitivität kann über eine Referenzspannung oder einen Schwellenwert geändert oder eingestellt werden. Die Auswertung des Informations- und Geschwindigkeitssignal kann durch einen separaten Mikrocontroller oder einer Steuereinheit erfolgen.

Da das Informationssignal periodisch mit jedem Puls des Geschwindigkeitssignal versandt wird, ist es optional möglich, die Drehzahl auch über das Informationssignal redundant zu ermitteln. Je nach Polrad können pro Umdrehung ca. 100 (oder mehr oder weniger) Pulse des Geschwindigkeitssignals, jeweils gefolgt von dem Informationssignal, gesendet werden.

Optional umfasst die Ansteuerschaltung eine Auswerteschaltung, die ausgebildet ist, um, basierend auf das Drehzahlsignal am Geschwindigkeitssignalausgang, die Drehzahl des Rades zu bestimmen. Die Auswerteschaltung kann weiter ausgebildet sein, um basierend auf die kodierte Information am Informationssignalausgang zumindest eine Information oder einen Zustand des aktiven Drehzahlsensors zu bestimmen.

Optional umfasst die Überwachungsschaltung zur unabhängigen Überwachung des ersten Anschlusses und/oder des zweiten Anschlusses Folgendes: einen ersten Statussignalanschluss, der mit dem ersten Anschluss verbunden ist (direkt oder indirekt), und/oder einen zweiten Statussignalanschluss, der mit dem zweiten Anschluss verbunden ist (direkt oder indirekt).

Optional ist die Auswerteschaltung weiter ausgebildet, um Signale von dem ersten Statussignalanschluss und/oder dem zweiten Statussignalanschluss zu empfangen, um einen Kurzschluss des ersten Anschlusses und/oder des zweiten Anschlusses und/oder ein Übersprechen (z.B. zwischen dem ersten und zweiten Anschluss) zu ermitteln. Der Kurzschluss kann zumindest eines aus dem Folgenden sein: Kurzschluss nach Masse (z.B. vom ersten und/oder vom zweiten Anschluss), Kurzschluss zur Versorgungsspannung (z.B. vom ersten und/oder vom zweiten Anschluss), Kurzschluss des ersten Anschlusses mit dem zweiten Anschluss.

Optional umfasst der Spannungskontroller einen Stromspiegel, um Stromänderungen infolge von Änderungen in der Versorgungspannung zu spiegeln und einen gespiegelte Strom zwischen dem ersten Schalter und dem ersten Anschluss einzuspeisen, um die Spannungsanpassung zu bewirken. Die Spannungsanpassung kann insbesondere ein Aufrechterhalten einer vorbestimmten Spannung sein. Gemäß Ausführungsbeispielen erfolgt auch dies ohne eine Logik oder eine separate Steuereinheit. Die Schaltung selbst regelt die Spannung automatisch auf das gewünschte Niveau nach.

Optional umfasst der Überstromdetektor einen ersten Überstromdetektor zur Detektion eines ersten Stromes zwischen dem Versorgungsanschluss und dem ersten Anschluss und/oder einen zweiten Überstromdetektor zur Detektion eines zweiten Stromes zwischen dem zweiten Anschluss und dem Masseanschluss.

Optional umfasst der erste Überstromdetektor einen ersten Filter, um Überstromereignisse unterhalb einer festen ersten Mindestzeitdauer herauszufiltern und bei Überschreiten der festen ersten Mindestzeitdauer den ersten Schalter zu öffnen. Der zweite Überstromdetektor kann optional einen zweiten Filter aufweisen, um Überstromereignisse unterhalb einer festen zweiten Mindestzeitdauer herauszufiltern und bei Überschreiten der festen zweiten Mindestzeitdauer den zweiten Schalter zu öffnen. Die erste Mindestzeitdauer kann gleich der zweiten Mindestzeitdauer sein oder unterschiedlich gewählt sein. Gemäß Ausführungsbeispielen erfolgt auch dies ohne eine Logik oder eine separate Steuereinheit. Die Mindestzeitdauern können in der Hardware fest eingestellt sein (z.B. über entsprechend gewählte Kondensatoren). Die Filter können als RC-Glieder ausgebildet werden und wirken als Dämpfungselemente, die eine Dämpfung bei der Detektion des Überstromes erreichen um eine gewünschte Trägheit zu implementieren.

Optional umfasst der erste Signaldetektor und/oder der zweite Signaldetektor jeweils einen Komparator mit einem Referenzspannungseingang und einen Sensorsignaleingang. Der Referenzspannungseingang des zweiten Signaldetektor ist mit dem Rückkoppelschalter verbunden, um ansprechend auf eine Detektion des Geschwindigkeitssignals durch ersten Signaldetektors einen Referenzspannungswert an dem Komparator des zweiten Signaldetektors zu ändern. Der Referenzspannungseingang kann beispielsweise ein nicht-invertierender oder ein invertierender Eingang eines Komparators sein. Der Sensorsignaleingang kann dementsprechend der invertierende oder der nicht-invertierende Eingang des Komparators sein. Wenn kein Sensorsignal anliegt, können die Referenzspannungswerte an den Referenzspannungseingängen vorbestimmte Werte aufweisen, die wiederum in der Hardware (z.B. über Spannungsteiler) kodiert sein können. Dafür sind keine aktiven Bauteile oder gar eine Logik erforderlich.

Die Überwachungsschaltung kann eine erste Überwachungsschaltung für einen ersten Drehzahlsensor sein. Optional ist außerdem eine zweite Überwachungsschaltung baugleich zur ersten Überwachungsschaltung für einen zweiten Drehzahlsensor ausgebildet. In gleicher Weise kann die Ausleseschaltung eine erste Ausleseschaltung sein und optional kann eine zweite Ausleseschaltung baugleich zur ersten Ausleseschaltung ausgebildet sein. Die jeweiligen ersten Signaldetektoren können dann als ein erster 4-Kanal-Komparator ausgebildet sein. Ebenso können die jeweiligen zweiten Signaldetektoren als ein zweiter 4-Kanal-Komparator ausgebildet sein.

Optional umfasst der Rückkoppelschalter eine Transistorschaltung, die ausgebildet ist, um den Referenzspannungswert des Komparators des zweiten Signaldetektors auf einen mittigen Amplitudenwert des Pulses des Geschwindigkeitssignals zu legen.

Weitere Ausführungsbeispiele beziehen sich auf ein Antiblockiersystem für ein Nutzfahrzeug mit zumindest einem aktiven Drehzahlsensor, wobei das System ein Steuergerät mit zumindest einer der zuvor beschrieben Ansteuerschaltungen aufweist. Es versteht sich, dass für jedes separate Rad typischerweise eine gesonderte Drehzahlmessung durchgeführt wird, sodass im Allgemeinen mehrere der genannte Ansteuerschaltungen ausgebildet sein können. Wie bereits dargelegt, können über die Nutzung von Mehr-Kanal-Komparatoren die Drehzahlerfassungen in einer Schaltung (z.B. auf eine Platine) kombiniert werden.

Weitere Ausführungsbeispiele beziehen sich auf ein Verfahren, welches ein Ansteuern und/oder Überwachen eines aktiven Drehzahlsensors in einem Fahrzeugs unter Verwendung einer oben genannten Ansteuerschaltung ausführt.

Optional kann das Verfahren ein Feststellen eines Kurzschlusses und/oder eines Übersprechens umfassen, wobei der Kurzschluss zu Masse oder zu dem Versorgungsanschluss vorliegen kann, und zwar von dem ersten und/oder dem zweiten Anschluss. Hierzu kann das Verfahren optional zumindest einen der folgenden Schritte ausführen:
- Eingabe eines ersten Signals auf dem ersten Statussignalanschluss,
- Eingabe eines zweiten Signals auf dem zweiten Statussignalanschluss,
- Analyse eines Signalstatus auf dem ersten Statussignalanschluss,
- Analyse eines Signalstatus auf dem zweiten Statussignalanschluss,
- Vergleich eines ersten Signalstatus auf dem ersten Statussignalanschluss mit einem zweiten Signalstatus auf dem zweiten Statussignalanschluss.

Ausführungsbeispiele bieten unter anderem die folgenden Vorteile: Die Ansteuerschaltung ist kostengünstig herstellbar und bietet ein hohes Maß an Zuverlässigkeit über lange Zeiträume. Hierzu werden keine speziellen Bauteile verwendet, sondern Standardbauteile genutzt, die nachweislich eine zuverlässige Arbeitsweise über Zeiträume von mehr als 10 oder mehr als 20 Jahren sicher ermöglichen. Hierzu werden beispielsweise diskrete Bauelemente oder Standardoperationsverstärker verwendet, die über weite Teile flexibel angepasst werden können und über die gesamte Lebensdauer den geforderten Anforderungen entsprechen.

Die Versorgungsspannung und Ströme können ständig überwacht werden, um optimale Bedingungen für den Drehzahlsensor bereitzustellen. Es ist eine getrennte Abschaltung der Versorgungsspannung sowohl auf der Seite des Masseanschlusses als auch auf der Seite des Versorgungsanschlusses vorgesehen. Es sind Eingänge ausgebildet, mit denen ganz gezielt bestimmte Funktionen getestet werden können. Außerdem ermöglichen Ausführungsbeispiele eine Anpassung der Versorgungsspannung an konkrete Drehzahlsensoren.

Die Ausführungsbeispiele der vorliegenden Erfindung werden besser verstanden von der folgenden detaillierten Beschreibung und den beiliegenden Zeichnungen der unterschiedlichen Ausführungsbeispiele, die jedoch nicht so verstanden werden sollten, dass sie die Offenbarung auf die spezifischen Ausführungsformen einschränken, sondern lediglich der Erklärung und dem Verständnis dienen.
- Fig. 1: zeigt eine Ansteuerschaltung gemäß einem Ausführungsbeispiel der vorliegenden Erfindung.
- Fig. 2A,2B: zeigen weitere optionale Schaltungen, die mit der Ansteuerschaltung aus der Fig. 1 kombiniert werden können.
- Fig. 3: zeigt ein beispielhaftes Sensorsignal eines möglichen aktiven Drehzahlsensors.
- Fig. 4: zeigt ein Ausführungsbeispiel für die Überwachungsschaltung mit weiteren Details.
- Fig. 5: zeigt ein Ausführungsbeispiel für die Ausleseschaltung mit weiteren Details.

Wenn im Folgenden ein Element als mit einem anderen Element als "verbunden" oder "gekoppelt" bezeichnet wird, kann es direkt mit dem anderen Element verbunden oder gekoppelt sein, oder es können dazwischenliegende weitere Elemente vorhanden sein. Wenn ein Element dagegen als "direkt verbunden" oder "direkt gekoppelt" mit einem anderen Element bezeichnet wird, sind keine Zwischenelemente vorhanden. Andere Wörter, die zur Beschreibung der Beziehung zwischen Elementen verwendet werden, sollten in gleicher Weise interpretiert werden (z. B. "zwischen" im Gegensatz zu "direkt zwischen", "benachbart" im Gegensatz zu "direkt angrenzend" usw.).

Die hier verwendete Terminologie dient nur zur Beschreibung illustrativer Ausführungsbeispiele und ist nicht als einschränkend zu verstehen. Die hier verwendeten Singularformen schließen auch die Pluralformen ein, sofern aus dem Kontext nicht eindeutig etwas anderes hervorgeht. Es versteht sich ferner, dass die Begriffe "umfassen" bzw. "aufweisen", wenn sie hier verwendet werden, das Vorhandensein bestimmter Merkmale, Schritte, Vorgänge, Elemente und/oder Komponenten bezeichnen, aber das Vorhandensein oder Hinzufügen eines oder mehrerer anderer Merkmale, Schritte, Vorgänge, Elemente, Komponenten und/oder Gruppen davon nicht ausschließen.

Sofern nicht anders definiert, haben alle hierin verwendeten Begriffe (einschließlich technischer und wissenschaftlicher Begriffe) die gleiche Bedeutung, wie sie von einem Fachmann auf dem Gebiet, zu dem die Beispiele gehören, gemeinhin verstanden wird. Es versteht sich ferner, dass Begriffe, z. B. solche, die in allgemein gebräuchlichen Wörterbüchern definiert sind, so ausgelegt werden sollten, dass sie eine Bedeutung haben, die mit ihrer Bedeutung im Kontext des einschlägigen Fachgebiets übereinstimmt, und dass sie nicht in einem idealisierten oder übermäßig formalen Sinne ausgelegt werden, sofern sie hier nicht ausdrücklich so definiert sind.

Schließlich ist die Formulierung, dass Elemente seriell/parallel zwischen zwei Komponenten geschaltet sind, im Sinne einer elektrischen Schaltung zu verstehen, und zwar in dem Sinn, dass die relative Lage der Komponenten zueinander entlang einer Stromrichtung definiert wird, wobei sich eine serielle Verschaltung oder eine parallele Verschaltung ergibt. Das Wort "zwischen" soll sich daher nicht notwendigerweise auf die physischen Lage oder Anordnung auf einen Schaltungssubstrats (z.B. Leiterplatine) beziehen.

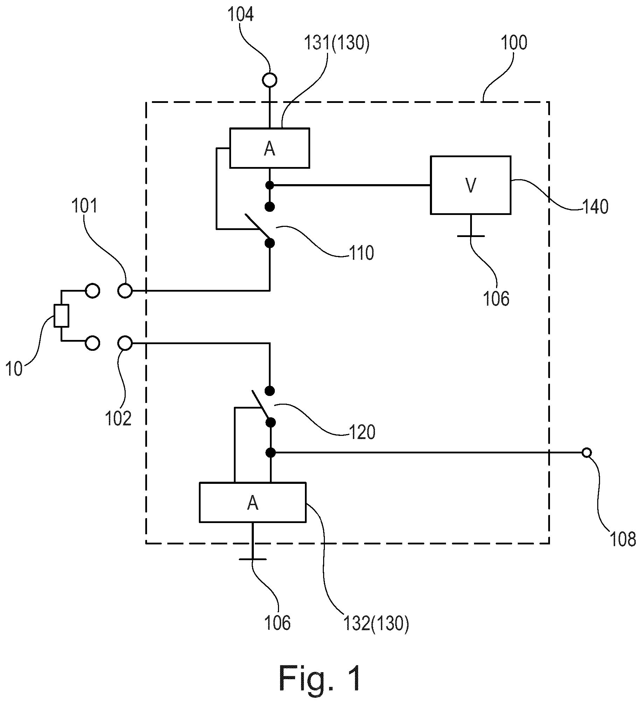

**Fig. 1** zeigt eine Ansteuerschaltung gemäß einem Ausführungsbeispiel. Die Ansteuerschaltung umfasst eine Überwachungsschaltung 100, die einen ersten Anschluss 101, einen zweiten Anschluss 102, einen Versorgungsanschluss 104 und einen Masseanschluss 106 aufweist. Außerdem umfasst die Überwachungsschaltung einen Sensorsignalausgang 108, einen ersten Schalter 110, einen zweiten Schalter 120, einen ersten und einen zweiten Überstromdetektor 131, 132 als auch einen Spannungskontroller 140. Zwischen dem ersten Anschluss 101 und dem zweiten Anschluss 102 kann der aktiver Drehzahlsensor 10 angeschlossen werden. Ausführungsbeispiele sollen aber nicht auf den Fall eingeschränkt sein, wo zwei unabhängige Stromdetektoren ausgebildet sind, sondern auch den Fall umfassen, wo nur der erste Stromdetektor 131 oder nur der zweite Stromdetektor 132 ausgebildet ist.

Zwischen dem Versorgungsanschluss 104 und dem ersten Anschluss 101 sind seriell hintereinander der erste Überstromdetektor 131 und der erste Schalter 110 geschaltet. Zwischen dem Masseanschluss 106 und dem zweiten Anschluss 102 sind seriell hintereinander der zweite Überstromdetektor 132 und der zweite Schalter 120 geschaltet. Die Reihenfolge der ersten und zweiten Schalter 110, 120 bzw. des ersten und zweiten Überstromdetektors 131, 132 können auch anders gewählt sein.

An einem Stromknoten zwischen dem ersten Schalter 110 und dem ersten Überstromdetektor 131 ist eine elektrische Verbindung zu dem Spannungskontroller 140 vorgesehen, der ausgebildet ist, um eine vorbestimmte Spannung an dem ersten Anschluss 101 zu regulieren. Zwischen dem zweiten Schalter 120 und dem zweiten Überstromdetektor 132 wird das Sensorsignal abgegriffen und über den Sensorsignalausgang 108 ausgegeben.

In dem vorliegenden Ausführungsbeispiel gibt der Drehzahlsensor 10 das Sensorsignal über den zweiten Anschluss 102 aus (auf der Masse-Seite) und kann daher über den Sensorsignalausgang 108 bei dem zweiten Schalter 120 abgegriffen werden. Dies ist jedoch nur ein Beispiel und nicht zwingend. Gemäß weiterer Ausführungsbeispiele kann der Drehzahlsensor 10 das Sensorsignal auch an dem ersten Anschluss 101 (auf der Seite der Versorgungsspannung) ausgeben, wobei dann der Sensorsignalausgang 108 vor oder hinter dem ersten Schalter 110 ausgebildet sein kann (z.B. an einem Eingang oder Ausgang des ersten Überstromdetektors 131).

Der erste Überstromdetektor 131 ist ausgebildet, um einen Strom von/zu dem Versorgungsanschluss 104 zu detektieren und beim Überschreiten eines Schwellwertes den ersten Schalter 110 zu öffnen. Der zweite Überstromdetektor 132 ist ausgebildet, um einen Strom zu/von dem Masseanschluss 106 zu detektieren und beim Überschreiten eines weiteren Grenzwertes den zweiten Schalter 120 zu öffnen.

Der erste Überstromdetektor 131 und/oder der zweite Überstromdetektor 132 umfassen optional Dämpfungsschaltungen, um den ersten Schalters 110 bzw. den zweiten Schalter 120 nur dann zu betätigen, wenn das Überschreiten des Schwellenwertes für eine vorbestimmte Mindestzeit erfolgt. Die vorbestimmte Mindestzeit wird durch eine Dimensionierung von passiven Bauelementen wie Kondensatoren und Widerständen eingestellt, nicht aber durch eine Logik.

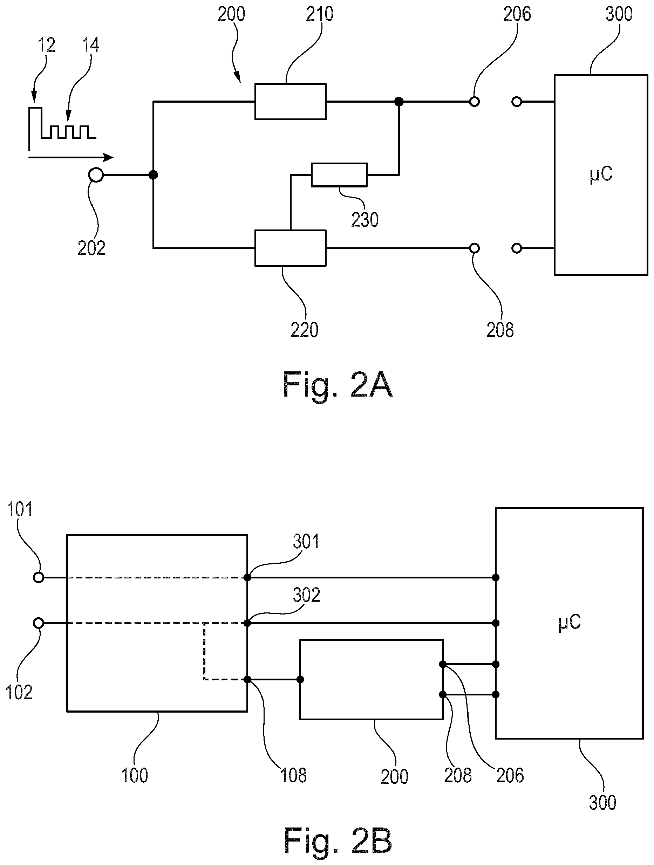

**Fig. 2A** und **Fig. 2B** zeigen weitere optionale Schaltungen, die gemäß Ausführungsbeispielen mit der Ansteuerschaltung aus der Fig. 1 kombiniert werden können.

In der **Fig. 2A** ist eine Ausleseschaltung 200 gemäß einem weiteren Ausführungsbeispiel dargestellt. Die Ausleseschaltung 200 umfasst einen Sensorsignaleingang 202, einen Geschwindigkeitssignalausgang 206 und einen Informationssignalausgang 208. Zwischen dem Sensorsignaleingang 202 und dem Geschwindigkeitssignalausgang 206 ist ein erster Signaldetektor 210 ausgebildet. Zwischen dem Sensorsignaleingang 202 und dem Informationssignalausgang 208 ist ein zweiter Signaldetektor 220 ausgebildet. Außerdem umfasst die Ausleseschaltung 200 einen Rückkoppelschalter 230, der ausgebildet ist, um ansprechend auf ein Ausgangssignal des ersten Signaldetektors 210 die Sensitivität des zweiten Signaldetektors 220 zu ändern.

Der Geschwindigkeitssignalausgang 206 und der Informationssignalausgang 208 können an eine Auswerteschaltung 300 wie beispielsweise einen Mikrokontroller angeschlossen sein. Der Sensorsignaleingang 202 kann mit dem Sensorsignalausgang 108 der Überwachungsschaltung 100 aus der Fig. 1 verbunden sein.

Während des Betriebes erfolgt die Eingabe eines Sensorsignals über den Sensorsignaleingang 202. Das Sensorsignal umfasst einen Geschwindigkeitspuls 12 und eine Vielzahl von Informationspulsen 14, die sich periodisch in Abhängigkeit der Drehzahl des Rades wiederholen können. Der erste Signaldetektor 210 ist ausgebildet, das Geschwindigkeitssignal 12 zu detektieren, wozu beispielsweise ein Schwellwertvergleich durchgeführt werden kann. Der Schwellenwert kann derart gewählt sein, dass der Amplitudenwert des Geschwindigkeitssignals 12 sicher erfasst wird, nicht aber zwingenderweise die Pulse des Informationssignals 14.

Ein Detektionssignal wird als Geschwindigkeitssignal am Geschwindigkeitssignalausgang 206 bereitgestellt. Es dient gleichzeitig als Auslösesignal für den Rückkoppelschalter 230, der in Antwort darauf die Sensitivität des zweiten Signaldetektors 220 ändert. Das kann dadurch geschehen, dass der Schwellenwert des zweiten Signaldetektors 220 durch den Rückkoppelschalter 230 angehoben wird, so dass der zweite Signaldetektor 220 möglichst alle Pulse, einschließlich des Pulses vom Geschwindigkeitssignals 12, mit einer gleichen Pulsbreite detektieren und als (binäre) Pulsfolge an den Informationssignalausgang 208 auszugeben kann. Der erste Puls (vom Geschwindigkeitssignal 12) kann dann als Auslösepuls dienen, um ansprechend darauf das nachfolgenden Informationssignal 14 zu dekodieren. Wenn der Schwellenwert des zweiten Signaldetektors 220 nicht angehoben werden würde, würde die Gefahr bestehen, dass der Puls des Geschwindigkeitssignals 12 aufgrund seiner größeren Amplitude deutlich breiter wäre als alle anderen Pulse. Diese künstliche Verbreiterung müsste ansonsten durch eine Signalnachbereitung in einem nachfolgenden Mikrokontroller beseitigt werden. Das Heraufsetzen des Schwellenwertes löst dieses Problem automatisch.

Auf diese Weise erhält die nachfolgende Auswerteschaltung 300 über den Geschwindigkeitssignalausgang 206 zum einen die Information des Vorliegens eines Geschwindigkeitspulses und kann aus dem zeitlichen Verlauf bzw. der Anzahl der Pulse pro Minute feststellen, wie schnell sich das Rad dreht, dessen Rotation durch den aktiven Drehzahlsensor ermittelt wird. Außerdem kann die Auswerteschaltung 300 über den Informationssignalausgang 208 weitere Informationen erhalten.

**Fig. 2B** zeigt ein Ausführungsbeispiel für eine mögliche Verschaltung der Überwachungsschaltung 100 (siehe Fig. 1), der Ausleseschaltung 200 und der Auswerteschaltung 300. An dem ersten Anschluss 101 und dem zweiten Anschluss 102 kann wiederum ein Drehzahlsensor angeschlossen werden, der durch die Überwachungsschaltung 100 einerseits mit einer Versorgungsspannung bzw. einem Strom versorgt wird und die erhaltenen Sensorsignale über den Sensorsignalausgang 108 ausgibt. Die Ausleseschaltung 200 separiert dann das Geschwindigkeitssignal 12 von dem Informationssignal 14 (siehe Fig. 2A) und leitet beide Signale separat an einer Auswerteschaltung 300 weiter.

Die Überwachungsschaltung 100 in dem Ausführungsbeispiel der Fig. 2B umfasst außerdem einen erste Statussignalanschluss 301 und einen zweiten Statussignalanschluss 302. Der erste Statussignalanschluss 301 koppelt elektrisch an den ersten Anschluss 101. Der zweite Statussignalanschluss 302 koppelt elektrisch an den zweiten Anschluss 102. Diese Eingänge 301, 302 sind für Statussignale vorgesehen, sodass die Auswerteschaltung 300 gezielt den ersten Anschluss 101 und den zweiten Anschluss 102 überwachen bzw. über eine gezielte Ansteuerung der Anschlüsse feststellen kann, ob ein Kurzschluss hin zur Versorgungsspannung oder hin zur Masse vorliegt. Zum Beispiel kann die Auswerteschaltung 300 gezielt Spannungspulse an die Anschlüsse leiten und deren Rückwirkung auf den Geschwindigkeitssignalausgang 206, den Informationssignalausgang 208, den Statussignalanschluss 301 bzw. Statussignalanschluss 302 analysieren. Die Auswerteschaltung 300 ist daher in der Lage, festzustellen, ob ein erwartetes Resultat an den Ausgängen 206, 208 ankommt. Falls das nicht der Falls ist, kann die Auswerteschaltung 300 einen Fehler feststellen (z.B. einen Kurzschluss).

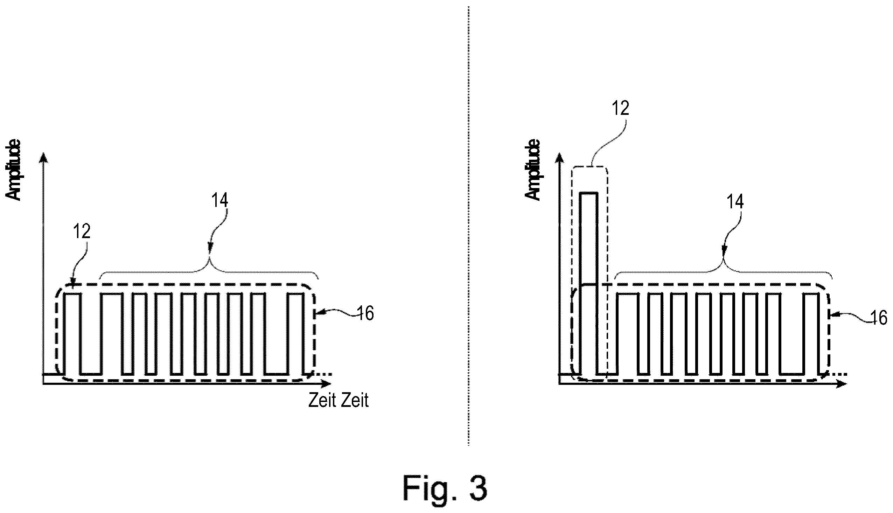

**Fig. 3** zeigt beispielhaft ein Sensorsignal 16, wie es durch einen aktiven Drehzahlsensor 10 ausgegeben werden kann, wobei die linke Seite den Zustand des Stillstandes bzw. der Bewegung mit sehr geringen Geschwindigkeiten zeigt. Auf der rechten Seite ist der Fahrzustand bzw. der Zustand mit höherer Geschwindigkeit dargestellt. Zur Unterscheidung von hohen/geringen Geschwindigkeiten kann ein vorbestimmter Grenzwert (z.B. 1 km/h) definiert werden.

Der aktive Drehzahlsensor 10 ist ausgebildet, auch im Fahrzeugstillstand ein Signal 16 auszugeben. Der erste Puls kann das Geschwindigkeitssignal 12 sein, auf welchem eine Vielzahl von Pulsen folgen, die das Informationssignal 14 bilden. Das Signal 16 ist beispielsweise ein Stromsignal mit variabler Stromstärke, wobei das Informationssignal 14 ein Binärsignal mit zwei vorbestimmten Amplitudenwert sein kann, zum Beispiel von 7 mA als Low-Zustand (logisch 0) bzw. 14 mA als High-Zustand (logisch 1). Das Geschwindigkeitssignal 12 kann im Fahrzustand beispielsweise einen Amplitudenwert in der Stromstärke von 28 mA aufweisen und bei Stillstand den High-Zustand annehmen. Diese Werte sind jedoch nur beispielhaft zu verstehen. Es ist ebenfalls möglich, dass gemäß weiteren Ausführungsbeispielen eine andere Kodierung erfolgt bzw., dass die Kodierung von dem konkreten aktiven Drehzahlsensor 10 abhängt.

Diese Signalfolge 16 wiederholt sich periodisch, wobei die Periode die Drehzahl des Rades ist, wodurch auch die maximale Informationsmenge in dem Informationssignal 14 begrenzt wird. Das Informationssignal 14 kann als Binärsignal den Zustand oder ein Identifikation des Drehzahlsensors 10 kodieren. Zur Kodierung kann beispielsweise ein Manchester Code genutzt werden. Hierbei wird die Gesamtsignallänge des Informationssignals 14 in vorbestimmte Zeitfenster unterteil (bei 10 Bit Kodierung in 10 Zeitfenster), wobei eine ansteigende Flanke innerhalb eines Zeitfensters logisch 1 darstellt und eine fallende Flanke innerhalb des Zeitfensters logisch 0 darstellt.

Der aktive Drehzahlsensor 10 kann beispielsweise ein Hall-Sensor oder ein anderer aktiver Drehzahlsensor sein, der das Geschwindigkeitssignal 12 und das Informationssignal 14 aktiv erzeugen und der Ansteuerschaltung bereitstellen kann. Ein Vorteil dieser aktiven Sensoren 10 besteht in der Übertragung der zusätzlichen Informationen, die im Informationssignal 14 kodiert sind. Insbesondere kann das Informationssignal 14 auch im Stillstand des Fahrzeuges übertragen werden, sodass bereits vor Fahrtbeginn eine Identifikation des eingebauten Drehzahlsensors 10 als auch ein Zustand des aktiven Drehzahlsensors 10 ermittelt werden kann. Mittels des Informationssignals 14 können beispielsweise verschiedene Parameter des aktiven Drehzahlsensors 10 ausgegeben werden, wie zum Beispiel: ob eine (korrekte) Spannung anliegt, ob eine vorbestimmte elektrische Stromstärke verfügbar ist oder andere elektrische Parameter, aus denen die korrekte Arbeitsweise des aktiven Drehzahlsensors ermittelt werden kann.

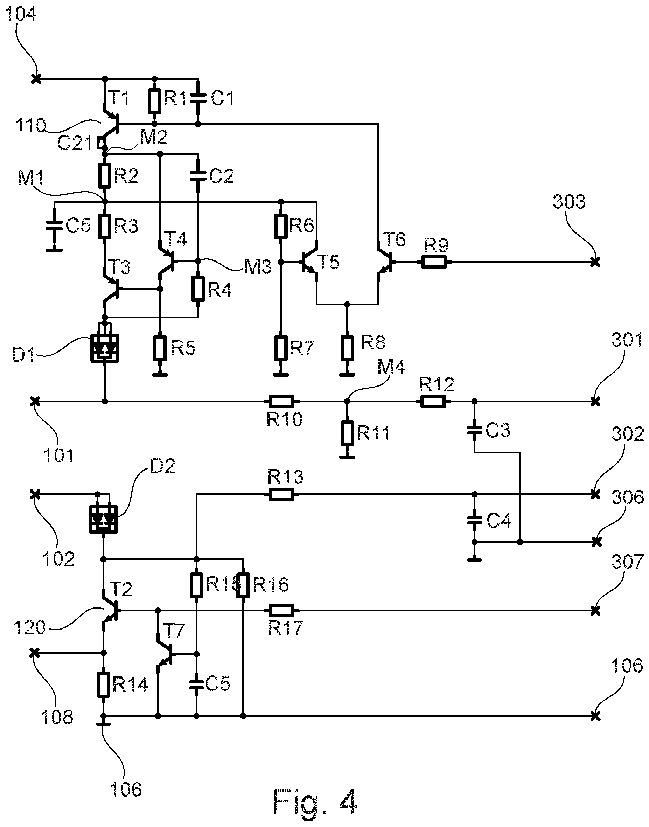

**Fig. 4** zeigt die Überwachungsschaltung 100 mit weiteren Details gemäß einem weiteren Ausführungsbeispiel. Die Überwachungsschaltung 100 umfasst folgende Anschlüsse: den ersten Anschluss 101, den zweiten Anschluss 102, den Versorgungsanschluss 104, den Masseanschluss 106, einen Sensorsignalausgang 108, einen erste Statussignalanschluss 301, einen zweiten Statussignalanschluss 302, einen Eingang für ein erstes Aktivierungssignal 303, einen Eingang für ein zweites Aktivierungssignal 307, einen weiteren Masseanschluss 306 (z.B. Masse der Auswerteschaltung 300).

Zwischen dem Versorgungsanschluss 104 und dem ersten Anschluss 101 sind folgende Elemente in Reihe geschaltet: ein erster Transistor T1, ein Widerstand R2, ein Widerstand R3, ein Transistor T3 und ein erster Gleichrichter D1. Das Element C21 deutet an, dass der Transistor T1 ein Leistungstransistor mit zwei Kollektoren sein kann, wobei beide Kollektoren miteinander verbunden sind. Der Transistor T1 ist mit einem Emitter an dem Versorgungsanschluss 104 geschaltet. Zwischen dem Kollektor des Transistor T1 und einem Emitter des Transistors T3 sind seriell die Widerstände R2 und R3 geschaltet. Ein Kollektor des Transistors T3 ist mit dem ersten Gleichrichter D1 verbunden, der zwischen dem ersten Anschluss 101 und dem Transistor T3 angeordnet ist. Ein Stromknoten M1 zwischen den Widerständen R2, R3 ist über einen Kondensator C5 mit Masse verbunden.

Zwischen dem Versorgungsanschluss 104 und dem Steueranschluss des Transistors T1 sind parallel ein Widerstand R1 und ein Kondensator C1 geschaltet. Ein Stromknoten M2 zwischen dem Kollektor des Transistors T1 und dem Widerstand R2 ist in einer seriellen Verschaltung eines Kondensators C2 und eines Widerstandes R4 mit dem Kollektor des Transistors T3 verbunden. Außerdem ist der Stromknoten M2 über eine serielle Verschaltung eines Transistors T4 und eines Widerstandes R5 mit Masse 106 verbunden, wobei der Emitter des Transistors T4 an dem Stromknoten M2 koppelt. Der Steueranschluss des Transistors T4 ist mit einem Stromknoten M3 zwischen dem Kondensator C2 und dem Widerstand R4 verbunden. Der Kollektor des Transistors T4 ist außerdem mit dem Steueranschluss des Transistors T3 verbunden.

Der Steueranschluss des Transistors T1 ist über eine serielle Schaltung eines Transistors T6 und eines Widerstands R8 mit Masse 106 verbunden, wobei ein Emitter des Transistors T6 mit dem Widerstand R8 verbunden ist und ein Kollektor des Transistors T6 mit dem Steueranschluss des Transistors T1 verbunden ist. Außerdem ist der Stromknoten M1 in einer seriellen Verschaltung mit einem Transistor T5 und dem Widerstand R8 mit Masse 106 verbunden, wobei ein Emitter des Transistors T5 zu dem Widerstand R8 verbunden ist. Der Stromknoten M1 ist außerdem über eine Schaltung eines Widerstands R6 und eines Widerstands R7 mit Masse 106 verbunden. Ein Stromknoten zwischen dem Widerstand R6 und dem Widerstand R7 ist mit einem Steueranschluss des Transistors T5 verbunden ist. Ein Steueranschluss des Transistors T6 ist über einen Widerstand R9 mit dem Eingang des ersten Aktivierungssignals 303 verbunden.

Zwischen dem ersten Anschluss 101 und dem ersten Statussignalanschluss 301 sind seriell ein Widerstand R10 und ein Widerstand R12 geschaltet. Ein Stromknoten M4 zwischen dem Widerstand R10 und dem Widerstand R12 ist über einen Widerstand R11 mit Masse 106 verbunden. Der erste Statussignalanschluss 301 ist über einen Kondensator C3 mit dem weiteren Masseanschluss 306 verbunden. Zwischen dem zweiten Anschluss 102 und dem zweiten Statussignalanschluss 302 sind seriell ein zweiter Gleichrichter D2 und ein Widerstand R13 geschaltet. Der zweite Statussignalanschluss 302 ist über einen Kondensator C4 mit dem weiteren Masseanschluss 306 verbunden. Der weitere Masseanschluss 306 kann mit dem Masseanschluss 106 verbunden sein (eine gemeinsame Masse bilden).

Zwischen dem zweiten Anschluss 102 und dem Masseanschluss 106 sind seriell der zweite Gleichrichter D2, ein Transistor T2 und ein Widerstand R14 geschaltet, wobei der Widerstand R14 zwischen dem Transistor T2 und dem Masseanschluss 106 ausgebildet ist und ein Emitter des Transistors T2 mit dem Widerstand R14 elektrisch verbunden ist. Außerdem ist ein Emitter des Transistors T2 mit dem Sensorsignalausgang 108 verbunden. Ein Kollektor des Transistors T2 ist über einen Widerstand R16 mit dem Masseanschluss 106 verbunden und in einer Parallelschaltung hierzu ist der Kollektor des Transistors T2 außerdem über einen Widerstand R15 und einem Kondensator C5 seriell mit dem Masseanschluss 106 verbunden. Ein Steueranschluss des Transistors T2 ist über einen Transistor T7 mit dem Masseanschluss 106 verbunden, wobei ein Emitter des Transistors T7 mit dem Masseanschluss 106 verbunden ist und ein Steueranschluss des Transistors T7 an einem Stromknoten zwischen dem Widerstand R15 und dem Kondensator C5 koppelt. Außerdem ist der Steueranschluss des Transistors T2 über einen Widerstand R17 mit dem Eingang 307 für das zweite Aktivierungssignal verbunden.

Die mit der Fig. 1 beschriebenen Funktionen: erster und zweiter Schalter 110, 120, Spannungskontroller 140, Überstromdetektoren 131, 132 werden durch die dargestellte Schaltung wie folgt erfüllt:
Der Transistor T1 bzw. der Transistor T3 können als ersten Schalter 110 genutzt werden, die über den Eingang 303 für das erste Aktivierungssignal angesteuert werden (geschaltet werden). Das erste Aktivierungssignal schaltet dabei zunächst den Transistor T6, der dann den Transistor T1 schaltet (z.B. schließt).

Der Transistor T5 bildet zusammen mit dem Transistor T6 einen Stromspiegel, der den Strom von dem Versorgungsanschluss 104 zu dem Masseanschluss 106 über den Transistor T6 spiegelt. Über diesen Stromspiegel wird der Spannungskontroller 140 erreicht, da der gespiegelte Strom an dem Stromknoten M1 zwischen den Widerständen R2 und R3 koppelt und entsprechend das Spannungsniveau dort erhöht oder senkt, so dass eine dynamische Nachjustierung des Spannungsniveaus erreicht wird (in Abhängigkeit des Stroms durch den Transistor T6). Das gewünschte Spannungsniveau wird über den Spannungsteiler mit den Widerstände R6, R7 eingestellt. Wenn zum Beispiel der Widerstandswert von R7 größer gewählt wird, erhöht sich auch der gespiegelte Strom durch den Transistor T5 und somit der Spannungswert am Stromknoten M1.

Der Transistor T4 (und ähnlich der Transistor T7) stellen den ersten Überstromdetektor 131 (zweiten Überstromdetektor 132) dar, die einen Stromfluss zwischen dem ersten Anschluss 101 und dem Versorgungsanschluss 104 detektieren und beim Überschreiten eines Schwellwertes, der über die Widerstandswerte bzw. die Schwellenspannung der Transistoren gegeben ist, zu einer Abschaltung des Transistors T3 (oder des Transistors T2) führen.

Der Widerstand R4 und der Kondensator C2 (bzw. der Widerstand R15 und der Kondensator C5) bilden ein Dämpfungsglied, so dass der Transistor T4 (bzw. T7) nicht bei kleineren Schwankungen sofort abschaltet, was zu einem Öffnen von dem Transistor T3 (bzw. T2) führen würde, sondern erst bei länger anhaltenden Überstromereignissen. Die Zeitkonstante hierfür wird über die Kapazität des Kondensators C2 (bzw. C5) eingestellt. Erst wenn der dadurch definierte (zeitliche) Schwellenwert überschritten ist, kommt es zu einer Abschaltung des Stromflusses zu dem oder von dem Versorgungsanschluss 104 (bzw. zum Masseanschluss 106).

Auf der Masseseite (sogenannte "low side") erfüllt der Transistor T2 die Funktion des zweiten Schalters 120, der über den Eingang 307 für das zweite Aktivierungssignal geschaltet wird. Wie bereits gesagt, der Transistor T7 erfüllt die Funktion des zweiten Überstromdetektors 132, der ein Abschalten auf der Masseseite bewirkt, wenn der Stromfluss und somit der Spannungsabfall über den Widerstand R14 zu hoch wird, was dazu führt, dass das Potential am Steueranschluss des Transistors T7 über einen Schwellwert ansteigt.

Der erste Gleichrichter D1 und der zweite Gleichrichter D2 können durch parallel geschaltete Dioden ausgebildet sein (z.B. um einen hohen Strom bei geringen Widerstand zu erlauben) und stellen sicher, dass ein gerichteter Stromfluss zu/von dem aktiven Drehzahlsensor erreicht wird.

Der Widerstand R12 und der Kondensator C3 bilden einen Filter (Tiefpass), um hochfrequente Anteile zu dem weiteren Masseanschluss 306 abzuleiten. In ähnlicher Weise bilden der Widerstand R13 und der Kondensator C4 einen Filter (Tiefpass), um an dem zweiten Anschluss 102 hochfrequente Anteile zu dem weiteren Masseanschluss 306 abzuleiten.

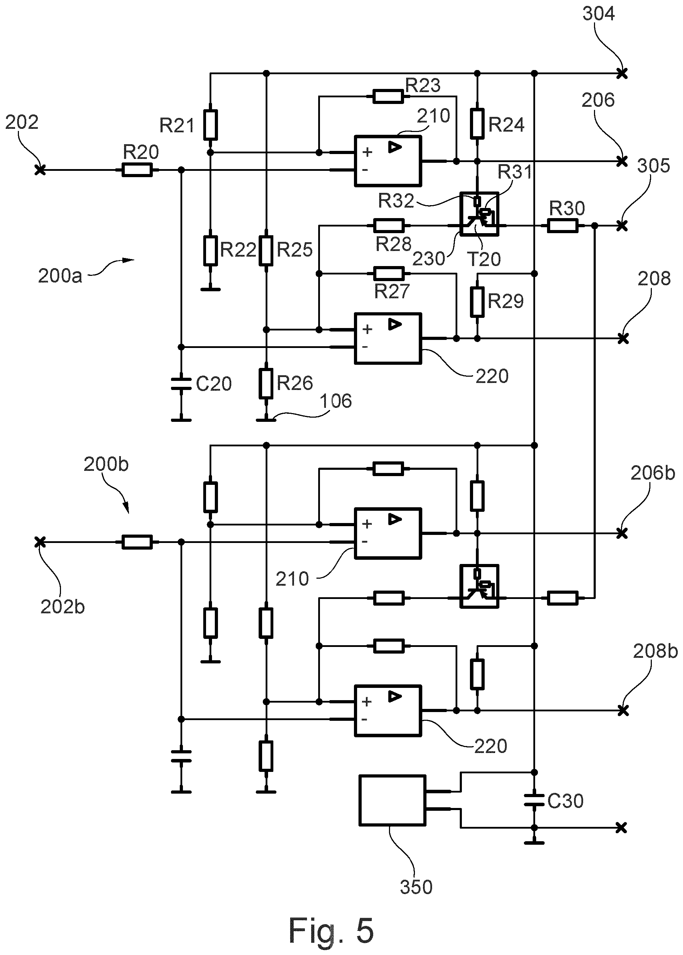

**Fig. 5** zeigt die Ausleseschaltung 200 mit weiteren Details gemäß einem weiteren Ausführungsbeispiel. Die Ausleseschaltung 200 umfasst eine erste Ausleseschaltung 200a und eine zweite Ausleseschaltung 200b, die spiegelsymmetrisch angeordnet sind, um Drehzahlsignale von zwei Rädern gleichzeitig auslesen zu können.

Die in der Fig. 5 oben gezeigte erste Ausleseschaltung 200a umfasst: den Sensorsignaleingang 202, eine erste Spannungsversorgung 304, den Geschwindigkeitssignalausgang 206, eine zweite Spannungsversorgung 305, den Informationssignalausgang 208 und den Masseanschluss 106. Die erste Spannungsversorgung 304 und die zweite Spannungsversorgung 305 können beispielsweise auf einem gleichen Potential liegen (elektrisch miteinander verbunden sein), können aber durch unterschiedliche Anschlüsse in der Schaltung ausgebildet sein, um verschiedene Potentiale anzulegen. Zwischen dem Sensorsignaleingang 202 und dem Geschwindigkeitssignalausgang 206 ist der erste Signaldetektor 210 geschaltet, wobei zwischen dem ersten Signaldetektor 210 und dem Sensorsignaleingang 202 außerdem ein Widerstand R20 ausgebildet ist. Der erste Signaldetektor 210 ist beispielhaft durch einen ersten Komparator mit einem invertierten Eingang (-) und einem nicht-invertierten Eingang (+) gebildet, wobei der invertierte Eingang (-) über den Widerstand R20 mit dem Sensorsignaleingang 202 verbunden ist und der Ausgang des Komparators 210 mit dem Geschwindigkeitssignalausgang 206 verbunden ist. Der invertierte Eingang (-) des ersten Komparators 210 ist außerdem über einen Kondensator C20 mit dem Masseanschluss 106 verbunden.

Der nicht-invertierten Eingang (+) des ersten Komparators 210 ist über einen Widerstand R21 mit der ersten Spannungsversorgung 304 und über einen Widerstand R22 mit dem Masseanschluss 106 elektrisch verbunden. Außerdem ist der Ausgang des ersten Komparators 210 über einen Widerstand R23 mit dem nicht-invertierten Eingang (+) elektrisch verbunden.

Der Sensorsignaleingang 206 ist außerdem seriell über den Widerstand R20 und dem zweiten Signaldetektor 220 mit dem Informationssignalausgang 208 elektrisch verbunden. Der zweite Signaldetektor 220 kann ebenfalls als ein zweiter Komparator mit einem invertierten Eingang (-) und einem nicht-invertierten Eingang (+) ausgebildet sein. Der nicht-invertierten Eingang (+) des zweiten Komparators 220 ist über einen Widerstand R27 mit dem Ausgang des zweiten Komparators 220 elektrisch verbunden. Außerdem ist der nicht-invertierten Eingang (+) des zweiten Komparators 220 über einen Widerstand R25 mit der ersten Spannungsversorgung 304 und über einen Widerstand R26 mit dem Masseanschluss 106 verbunden. Der Ausgang des zweiten Signaldetektors 220 ist über einen Widerstand R29 mit der ersten Spannungsversorgung 304 verbunden.

Die Rückkoppelschaltung 230 ist als Transistorschaltung ausgebildet und umfasst beispielsweise einen Transistor T20, wobei ein Emitter des Transistors T20 über einen Widerstand R30 mit der zweiten Spannungsversorgung 305 verbunden ist und der Kollektor des Transistors T20 über einen Widerstand R28 mit dem nicht-invertierten Eingang (+) des zweiten Komparators 220 verbunden ist. Der Steueranschluss des Transistors T20 ist über einen Widerstand R32 mit dem Ausgang des ersten Komparators 210 verbunden. Der Steueranschluss des Transistors T20 ist außerdem mit dem Emitter des Transistors T20 über einen Widerstand R31 elektrisch verbunden.

Die in der Fig. 5 unten dargestellte zweite Ausleseschaltung 200b ist in gleicher Weise aufgebaut, wie die erste Ausleseschaltung 200a. Da die zweite Ausleseschaltung 220b zur Drehzahlerfassung eines anderen Rades vorgesehen ist, sind die folgenden Anschlüsse separat ausgebildet: der Sensorsignaleingang 202b, der Geschwindigkeitssignalausgang 206b und der Informationssignalausgang 208b. Die anderen Anschlüsse sind gemäß dem gezeigte Ausführungsbeispiel miteinander verbunden, d.h. beide Ausleseschaltungen teilen sich die erste Spannungsversorgung 304 und die zweite Spannungsversorgung 305 und den Masseanschluss 106.

Gemäß weiteren Ausführungsbeispielen sind die jeweiligen ersten Signaldetektoren 210 als ein erster 4-Kanal-Komparator 210 ausgebildet sind. Ebenso können die jeweiligen zweiten Signaldetektoren als ein zweiter 4-Kanal-Komparator 220 ausgebildet sein. Auf diese Weise lassen sich die Schaltungen kompakt realisieren. Gemäß weiteren Ausführungsbeispielen ist der erste Komparator 210 zusammen mit dem zweiten Komparator 220 als ein 4-Kanal Komparator ausgebildet, z.B. als 2-kanalige Auswerteschaltung.

Gemäß weiterer Ausführungsbeispiele ist eine Versorgungseinheit 350 für eine Stromversorgung der Komparatoren vorgesehen, die zwei Anschlüsse aufweist, wovon einer mit der ersten Spannungsversorgung 304 und ein zweiter mit dem Masseanschluss 106 verbunden ist. Beide Anschlüsse sind außerdem über einen Kondensator C30 miteinander verbunden, um beispielsweise hochfrequente Anteile zu filtern.

Die mit der Fig. 2A beschriebenen Funktionen sind in diesem Ausführungsbeispiel wie folgt umgesetzt. Die Funktion der Ausleseschaltung 200 besteht in dem Trennen des Geschwindigkeitssignal 12 von dem Informationssignals 14, was durch eine Anpassung der Schwellenwerte für die Detektion umgesetzt wird und wie folgt beschrieben werden kann.

Der erste Komparator 210 und der zweite Komparator 220 vergleichen jeweils das Sensorsignal am Sensorsignaleingang 202 mit jeweiligen Referenzwerten (Schwellenwerten) an den nicht-invertierten Eingängen (+) der Komparatoren 210, 220. Der Referenzwert an dem ersten Komparator 210 kann so gewählt werden, dass er sicher das Geschwindigkeitssignale 12 detektiert, nicht aber die Informationssignale 14. Daher können am Sensorsignalausgang 206 nur die Pulse des Geschwindigkeitssignal 12 ausgegeben werden, aus deren Frequenz die Drehzahl des Rades ermittelbar ist (bei jeder Umdrehung kommt z.B. ein Puls oder auch 100 Pulse). Wenn dieser Puls anliegt, schaltet der Transistor T20 die Verbindung des nicht-invertierten Eingangs (+) des zweiten Komparators 220 zu der zweiten Spannungsversorgung 305. Dadurch wird beim Vorliegen des Geschwindigkeitspulses 12 die Referenzspannung am zweiten Komparator 220 geändert.

Die Referenzspannung am zweiten Komparator 220 kann vor dem Ändern so gewählt sein, dass der zweite Komparator 220 alle Pulse des Informationssignals 14 sicher detektieren und das Informationssignal 14 entsprechend ausgeben kann. Der Puls des Geschwindigkeitssignals 12 ist jedoch höher und der Kondensator C20 kann dazu führen, dass der Geschwindigkeitspuls 12 auf der Höhe der Pulse des Informationssignals 14 verbreitert wird und nur darüber eine gleiche Pulsbreite aufweist wie die Pulse des Informationssignals 14. Um eine gleiche Pulsbreite für alle Pulse zu erreichen, bewirkt der Rückkoppelschalter 230, dass die Referenzspannung am zweiten Komparator 220 während des Pulses des Geschwindigkeitssignals 12 angehoben wird, sodass die Detektion bei einem Wert erfolgt, wo der Geschwindigkeitspuls 12 idealerweise eine gleiche Breite aufweist wie die Pulse des Informationssignals 14. Diese "Höhenverschiebung" wird durch die Wahl der Widerstände R28, R30 geregelt.

Als Folge werden alle Pulse mit einer gleichen Pulsbreite detektiert. Die Auswertung erfolgt dann in der Auswerteschaltung 300.

### BEZUGSZEICHENLISTE

- 10: (aktiver) Drehzahlsensor
- 12: Geschwindigkeitssignal
- 14: Informationssignal
- 100: Überwachungsschaltung
- 101, 102: erster Anschluss, zweiter Anschluss
- 104: Versorgungsanschluss
- 106, 306: Masseanschlüsse
- 108: Sensorsignalausgang
- 110: erster Schalter
- 120: zweiter Schalter
- 130,131,132: Überstromdetektor(en)
- 140: Spannungskontroller
- 200: Ausleseschaltung
- 202: Sensorsignaleingang
- 206: Geschwindigkeitssignalausgang
- 208: Informationssignalausgang
- 210: erster Signaldetektor
- 220: zweiter Signaldetektor
- 230: Rückkoppelschalter
- 300: Auswerteschaltung
- 301,302: Statussignalanschlüsse
- 303, 307: Eingänge für Aktivierungssignale
- 304: erste Spannungsversorgung
- 305: zweite Spannungsversorgung
- 350: Einstelleinheit für die Versorgungsspannung
- R1, R2, ...: verschiedene Widerstände
- C1, C2, ...: diverse Kondensatoren
- D1, D2, ...: Gleichrichter
- T1, T2,...: diverse Transistoren

## Patentansprüche

1. Eine Ansteuerschaltung für einen aktiven Drehzahlsensor (10) eines Fahrzeuges, wobei der aktive Drehzahlsensor (10) ausgebildet ist, um eine Drehzahl eines Rades zu erfassen und darauf basierend ein Sensorsignal auszugeben, umfassend eine Überwachungsschaltung (100), die Folgendes aufweist:
- einen ersten Anschluss (101) und einen zweiten Anschluss (102) zum elektrischen Anschluss des Drehzahlsensors (10) und zum Empfangen des Sensorsignals;
- einen Versorgungsanschluss (104) zum Anschluss an eine Versorgungsspannung DEs FAHRZEUGS und einen Masseanschluss (106) zum Anschluss an eine Masse;
- einen Sensorsignalausgang (108) zum Bereitstellen des Sensorsignals vom aktiven Drehzahlsensor (10);
- einen ersten Schalter (110), der ausgebildet ist, um den ersten Anschluss (101) mit dem Versorgungsanschluss (104) zu schalten;
- einen zweiten Schalter (120), der ausgebildet ist, um den zweiten Anschuss (102) mit dem Masseanschluss (106) zu schalten;
- einen Überstromdetektor (130), der ausgebildet ist, um einen Überstrom durch den Versorgungsanschluss (104) oder durch den Masseanschluss (106) zu detektieren und auf eine Detektion den ersten Schalter (110) oder den zweiten Schalter (120) zu öffnen; und
- einen Spannungskontroller (140), der ausgebildet ist, um eine Anpassung einer elektrischen Spannung zwischen dem ersten Anschluss (101) und dem Masseanschluss (106) an einen Sollwert zu bewirken.

2. Ansteuerschaltung nach Anspruch 1, wobei das Sensorsignal ein Geschwindigkeitssignal (12) mit einem Puls und ein Informationssignal (14) mit einer Vielzahl von Pulsen aufweist, wobei die Pulse des Informationssignals (14) eine Information über den Drehzahlsensor (10) kodieren und eine kleinere Amplitude aufweisen als das Geschwindigkeitssignals (12),
**gekennzeichnet durch**
eine Ausleseschaltung (200), die Folgendes aufweist:
- einen Sensorsignaleingang (202), der mit dem Sensorsignalausgang (108) verbunden ist;
- einen Geschwindigkeitssignalausgang (206) und einen Informationssignalausgang (208);
- einen ersten Signaldetektor (210), der mit dem Sensorsignaleingang (202) verbunden und ausgebildet ist, um das Geschwindigkeitssignal (12) zu detektieren und basierend darauf ein Drehzahlsignal am Geschwindigkeitssignalausgang (206) bereitzustellen;
- einen zweiten Signaldetektor (220), der mit dem Sensorsignaleingang (202) verbunden und ausgebildet ist, um das Informationssignal (14) zu detektieren und die kodierten Information über den Drehzahlsensor (10) am Informationssignalausgang (208) bereitzustellen; und
- einen Rückkoppelschalter (230), der ausgebildet ist, auf eine Detektion des Geschwindigkeitssignals (12) durch den ersten Signaldetektor (210) zur Detektion des Informationssignals (14) eine Sensitivität des zweiten Signaldetektor (220) zu ändern.

3. Ansteuerschaltung nach Anspruch 2,
**gekennzeichnet durch**
eine Auswerteschaltung (300), die ausgebildet ist, um
- basierend auf das Drehzahlsignal am Geschwindigkeitssignalausgang (206) die Drehzahl des Rades zu bestimmen, und
- basierend auf die kodierte Information am Informationssignalausgang (208) zumindest eine Information oder einen Zustand des aktiven Drehzahlsensors (10) zu bestimmen.

4. Ansteuerschaltung nach einem der vorhergehenden Ansprüche,
**dadurch gekennzeichnet, dass**
die Überwachungsschaltung (100) zur unabhängige Überwachung des ersten Anschlusses (101) und des zweiten Anschlusses (102) Folgendes aufweist:
- einen ersten Statussignalanschluss (301), der mit dem ersten Anschluss (101) verbunden ist, und/oder
- einen zweiten Statussignalanschluss (302), der mit dem zweiten Anschluss (102) verbunden ist.

5. Ansteuerschaltung nach Anspruch 4, soweit rückbezogen auf Anspruch 3,
**dadurch gekennzeichnet, dass**
die Auswerteschaltung (300) weiter ausgebildet ist, um Signale von dem ersten Statussignalanschluss (301) und dem zweiten Statussignalanschluss (302) zu empfangen, um einen Kurzschluss des ersten Anschlusses (101) und/oder des zweiten Anschlusses (102) oder ein Übersprechen zu ermitteln, wobei der Kurzschluss zumindest eines aus dem Folgende ist: ein Kurzschluss nach Masse, ein Kurzschluss zur Versorgungsspannung, ein Kurzschluss des ersten Anschlusses (101) mit dem zweiten Anschluss (102).

6. Ansteuerschaltung nach einem der vorhergehenden Ansprüche,
**dadurch gekennzeichnet, dass**
der Spannungskontroller (140) einen Stromspiegel aufweist, um Stromänderungen infolge von Änderungen in der Versorgungspannung zu spiegeln und einen gespiegelte Strom zwischen dem ersten Schalter (110) und dem ersten Anschluss (101) einzuspeisen, um die Spannungsanpassung zu bewirken.

7. Ansteuerschaltung nach einem der vorhergehenden Ansprüche,
**dadurch gekennzeichnet, dass**
der Überstromdetektor (130) Folgendes aufweist:
- einen ersten Überstromdetektor (131) zur Detektion eines ersten Stromes zwischen dem Versorgungsanschluss (104) und dem ersten Anschluss (101) und/oder
- einen zweiten Überstromdetektor (132) zur Detektion eines zweiten Stromes zwischen dem zweiten Anschluss (102) und dem Masseanschluss (106).

8. Ansteuerschaltung nach Anspruch 7,
**dadurch gekennzeichnet, dass**
- der ersten Überstromdetektor (131) einen ersten Filter aufweist, um Überstromereignisse unterhalb einer festen ersten Mindestzeitdauer herauszufiltern und bei Überschreiten der festen ersten Mindestzeitdauer den ersten Schalter (110) zu öffnen, und/oder
- der zweite Überstromdetektor (132) einen zweiten Filter aufweist, um Überstromereignisse unterhalb einer festen zweiten Mindestzeitdauer herauszufiltern und bei Überschreiten der festen zweiten Mindestzeitdauer den zweiten Schalter (120) zu öffnen.

9. Ansteuerschaltung nach einem der Ansprüche 2 oder 3 bis 8, soweit rückbezogen auf Anspruch 2,
**dadurch gekennzeichnet, dass**
der erste Signaldetektor (210) und der zweite Signaldetektor (220) jeweils einen Komparator mit einem Referenzspannungseingang (+) und einen Sensorsignaleingang (-) aufweisen, wobei der Referenzspannungseingang (+) des zweiten Signaldetektor (220) mit dem Rückkoppelschalter (230) verbunden ist, um ansprechend auf eine Detektion des Geschwindigkeitssignals (12) durch ersten Signaldetektors (210) einen Referenzspannungswert an dem Komparator des zweiten Signaldetektors (220) zu ändern.

10. Ansteuerschaltung nach Anspruch 9,
wobei die Überwachungsschaltung (100) eine erste Überwachungsschaltung (100a) für einen ersten Drehzahlsensor ist und eine zweite Überwachungsschaltung (100b) baugleich zur ersten Überwachungsschaltung (100a) für einen zweiten Drehzahlsensor ausgebildet ist,
und wobei die Ausleseschaltung (200) eine erste Ausleseschaltung (200a) ist und eine zweite Ausleseschaltung (200b) baugleich zur ersten Ausleseschaltung (200a) ausgebildet ist,
**dadurch gekennzeichnet, dass**
die jeweiligen ersten Signaldetektoren als ein erster 4-Kanal-Komparator (210) ausgebildet sind, und/oder
die jeweiligen zweiten Signaldetektoren als ein zweiter 4-Kanal-Komparator (220) ausgebildet sind, und/oder
der erste Signaldetektor (210) und der zweite Signaldetektor (220) einer jeweiligen Ausleseschaltung (200a, 200b) als ein 4-Kanal-Komparator gebildet ist.

11. Ansteuerschaltung nach Anspruch 9 oder Anspruch 10,
**dadurch gekennzeichnet, dass**
wobei der Rückkoppelschalter (230) eine Transistorschaltung umfasst, die ausgebildet ist, um den Referenzspannungswert des Komparators des zweiten Signaldetektors (220) auf einen Amplitudenwert des Geschwindigkeitssignals zu legen, sodass der zweite Signaldetektor (220) alle Pulse möglichst mit gleicher Pulsbreite detektiert.

12. Antiblockiersystem für ein Nutzfahrzeug mit zumindest einem aktiven Drehzahlsensoren (10),
**gekennzeichnet durch**
ein Steuergerät mit zumindest einer Ansteuerschaltung nach einem der Ansprüche 1 bis 11.

13. Verfahren
**gekennzeichnet durch**
Ansteuern und Überwachen eines aktiven Drehzahlsensors (10) eines Fahrzeugs unter Verwendung einer Ansteuerschaltungen nach einem der Ansprüche 1 bis 11.

14. Verfahren nach Anspruch 13, welches zum Feststellen eines Kurzschlusses und/oder eines Übersprechens weiter zumindest einen der folgenden Schritte aufweist:
- Eingabe eines ersten Signals auf dem ersten Statussignalanschluss (301),
- Eingabe eines zweiten Signals auf dem zweiten Statussignalanschluss (302),
- Analyse eines Signalstatus auf dem ersten Statussignalanschluss (301),
- Analyse eines Signalstatus auf dem zweiten Statussignalanschluss (302),
- Vergleich eines Signalstatus auf dem ersten Statussignalanschluss (301) und dem zweiten Statussignalanschluss (302).

## Claims

1. Control circuit for an active rotational speed sensor (10) of a vehicle, wherein the active rotational speed sensor (10) is configured to detect a rotational speed of a wheel and to output a sensor signal based thereon, comprising a monitoring circuit (100) which has the following:
- a first terminal (101) and a second terminal (102) for the electrical connection of the rotational speed sensor (10) and for receiving the sensor signal;
- a supply terminal (104) for connection to a supply voltage of the vehicle and a ground terminal (106) for connection to a ground;
- a sensor signal output (108) for providing the sensor signal from the active rotational speed sensor (10);
- a first switch (110), which is configured to switch the first terminal (101) with the supply terminal (104);
- a second switch (120), which is configured to switch the second terminal (102) with the ground terminal (106);
- an overcurrent detector (130), which is configured to detect an overcurrent through the supply terminal (104) or through the ground terminal (106) and, upon detection, to open the first switch (110) or the second switch (120); and
- a voltage controller (140), which is configured to affect an adjustment of an electrical voltage between the first terminal (101) and the ground terminal (106) to a setpoint value.

2. Control circuit according to claim 1, wherein the sensor signal has a speed signal (12) with one pulse and an information signal (14) with a plurality of pulses, wherein the pulses of the information signal (14) encode a piece of information about the rotational speed sensor (10) and have a smaller amplitude than the speed signal (12),
**characterized by**
a read-out circuit (200) having the following:
- a sensor signal input (202) which is connected to the sensor signal output (108);
- a speed signal output (206) and an information signal output (208);
- a first signal detector (210), which is connected to the sensor signal input (202) and is configured to detect the speed signal (12) and provide a speed signal at the speed signal output (206) based thereon;
- a second signal detector (220), which is connected to the sensor signal input (202) and is configured to detect the information signal (14) and provide the encoded information about the rotational speed sensor (10) at the information signal output (208); and
- a feedback switch (230), which is configured to change a sensitivity of the second signal detector (220) in response to a detection of the speed signal (12) by the first signal detector (210) for detecting the information signal (14).

3. Control circuit according to claim 2,
**characterized by**
an evaluation circuit (300) which Is configured
- to determine the rotational speed of the wheel based on the speed signal at the speed signal output (206), and
- to determine at least one piece of information or a state of the active rotational speed sensor (10) based on the encoded information at the information signal output (208).

4. Control circuit according to any one of the preceding claims,
**characterized in that**
the monitoring circuit (100) for independently monitoring the first terminal (101) and the second terminal (102) has the following:
- a first status signal terminal (301) connected to the first terminal (101), and/or
- a second status signal terminal (302) connected to the second terminal (102).

5. Control circuit according to claim 4, provided that it refers back to claim 3,
**characterized in that**
the evaluation circuit (300) is further configured to receive signals from the first status signal terminal (301) and the second status signal terminal (302), to determine a short circuit of the first terminal (101) and/or the second terminal (102) or a crosstalk, wherein the short circuit is at least one of the following: a short circuit to ground, a short circuit to the supply voltage, a short circuit of the first terminal (101) with the second terminal (102).

6. Control circuit according to any of the preceding claims,
**characterized in that**
the voltage controller (140) has a current mirror for mirroring current changes resulting from changes in the supply voltage and for feeding a mirrored current between the first switch (110) and the first terminal (101) in order to affect the voltage adjustment.

7. Control circuit according to any one of the preceding claims,
**characterized in that**
the overcurrent detector (130) has the following:
- a first overcurrent detector (131) for detecting a first current between the supply terminal (104) and the first terminal (101) and/or
- a second overcurrent detector (132) for detecting a second current between the second terminal (102) and the ground terminal (106).

8. Control circuit according to claim 7,
**characterized in that**
- the first overcurrent detector (131) has a first filter for filtering out overcurrent events below a fixed first minimum time period, and for opening the first switch (110) when the fixed first minimum time period is exceeded, and/or
- the second overcurrent detector (132) has a second filter for filtering out overcurrent events below a fixed second minimum time period, and for opening the second switch (120) when the fixed second minimum time period is exceeded.

9. Control circuit according to any one of claims 2 or 3 to 8, provided that they refer back to claim 2,
**characterized in that**
the first signal detector (210) and the second signal detector (220) each have a comparator with a reference voltage input (+) and a sensor signal input (-), wherein the reference voltage input (+) of the second signal detector (220) is connected to the feedback switch (230), in order to change a reference voltage value at the comparator of the second signal detector (220) in response to a detection of the speed signal (12) by the first signal detector (210).

10. Control circuit according to claim 9,
wherein the monitoring circuit (100) is a first monitoring circuit (100a) for a first rotational speed sensor, and a second monitoring circuit (100b) is configured to be structurally identical to the first monitoring circuit (100a) for a second rotational speed sensor, and wherein the read-out circuit (200) is a first read-out circuit (200a), and a second read-out circuit (200b) is configured to be structurally identical to the first read-out circuit (200a),
**characterized in that**
the respective first signal detectors are configured as a first 4-channel comparator (210), and/or
the respective second signal detectors are configured as a second 4-channel comparator (220), and/or
the first signal detector (210) and the second signal detector (220) of a respective read-out circuit (200a, 200b) are configured as a 4-channel comparator.

11. Control circuit according to claim 9 or claim 10,
**characterized in that**
the feedback switch (230) comprises a transistor circuit which is configured to apply the reference voltage value of the comparator of the second signal detector (220) to an amplitude value of the speed signal, so that the second signal detector (220) detects all pulses as far as possible with the same pulse width.

12. Anti-lock braking system for a commercial vehicle with at least one active rotational speed sensor (10),
**characterized by**
a control device with at least one control circuit according to any one of claims 1 to 11.

13. Method
**characterized by**
controlling and monitoring an active rotational speed sensor (10) of a vehicle using a control circuit according to any one of claims 1 to 11.

14. Method according to claim 13, which further has at least one of the following steps for detecting a short circuit and/or a crosstalk:
- inputting a first signal at the first status signal terminal (301),
- inputting a second signal at the second status signal terminal (302),
- analyzing a signal status at the first status signal terminal (301),
- analyzing a signal status at the second status signal terminal (302),
- comparing a signal status at the first status signal terminal (301) and the second status signal terminal (302).

## Revendications

1. Circuit de commande pour un capteur de vitesse de rotation (10) actif d'un véhicule, dans lequel le capteur de vitesse de rotation (10) actif est configuré afin de détecter une vitesse de rotation d'une roue et d'émettre sur cette base un signal de capteur comprenant un circuit de surveillance (100) qui présente ce qui suit :
- un premier raccord (101) et un second raccord (102) pour le raccordement électrique du capteur de vitesse de rotation (10) et pour la réception du signal de capteur ;
- un raccord d'alimentation (104) pour le raccordement à une tension d'alimentation DU VÉHICULE et un raccord de masse (106) pour le raccordement à une masse ;
- une sortie de signal de capteur (108) pour la fourniture du signal de capteur du capteur de vitesse de rotation (10) actif ;
- un premier commutateur (110) qui est configuré afin de commuter le premier raccord (101) avec le raccord d'alimentation (104) ;
- un second commutateur (120) qui est configuré afin de commuter le second raccord (102) avec le raccord de masse (106) ;
- un détecteur de surintensité (130) qui est configuré afin de détecter une surintensité par le raccord d'alimentation (104) ou par le raccord de masse (106) et en cas de détection d'ouvrir le premier commutateur (110) ou le second commutateur (120) ; et
- un contrôleur de tension (140) qui est configuré afin de provoquer une adaptation d'une tension électrique entre le premier raccord (101) et le raccord de masse (106) à une valeur de consigne.

2. Circuit de commande selon la revendication 1, dans lequel le signal de capteur présente une signal de vitesse (12) avec une impulsion et un signal d'information (14) avec une pluralité d'impulsions, dans lequel les impulsions du signal d'information (14) codent une information relative au capteur de vitesse de rotation (10) et présentent une amplitude inférieure à celle du signal de vitesse (12),
**caractérisé par**
un circuit de lecture (200) qui présente ce qui suit :
- une entrée de signal de capteur (202) qui est reliée à la sortie de signal de capteur (108) ;
- une sortie de signal de vitesse (206) et une sortie de signal d'information (208) ;
- un premier détecteur de signal (210) qui est relié à l'entrée de signal de capteur (202) et configuré afin de détecter le signal de vitesse (12) et de fournir sur cette base un signal de vitesse de rotation à la sortie de signal de vitesse (206) ;
- un second détecteur de signal (220) qui est relié à l'entrée de signal de capteur (202) et configuré afin de détecter le signal d'information (14) et de fournir l'information codée relative au capteur de vitesse de rotation (10) à la sortie de signal d'information (208) ; et
- un commutateur de rétrocouplage (230) qui est configuré afin de modifier une sensibilité du second détecteur de signal (220) en cas de détection du signal de vitesse (12) par le premier détecteur de signal (210) pour la détection du signal d'information (14).

3. Circuit de commande selon la revendication 2,
**caractérisé par**
un circuit d'évaluation (300) qui est configuré afin de
- déterminer la vitesse de rotation de la roue sur la base du signal de vitesse de rotation au niveau de la sortie de signal de vitesse (206) et
- déterminer au moins une information ou un état du capteur de vitesse de rotation (10) actif sur la base de l'information codée au niveau de la sortie de signal d'information (208).

4. Circuit de commande selon l'une quelconque des revendications précédentes,
**caractérisé en ce que**
le circuit de surveillance (100) présente ce qui suit pour la surveillance indépendante du premier raccord (101) et du second raccord (102) :
- un premier raccord de signal de statut (301) qui est relié au premier raccord (101) et/ou
- un second raccord de signal de statut (302) qui est relié au second raccord (102).

5. Circuit de commande selon la revendication 4, dans la mesure où elle se réfère à la revendication 3,
**caractérisé en ce que**
le circuit d'évaluation (300) est en outre configuré afin de recevoir des signaux du premier raccord de signal de statut (301) et du second raccord de signal de statut (302) afin de déterminer un court-circuit du premier raccord (101) et/ou du second raccord (102) ou une diaphonie, dans lequel le court-circuit est au moins un parmi les suivants : un court-circuit à la masse, un court-circuit à l'alimentation de tension, un court-circuit du premier raccord (101) avec le second raccord (102).

6. Circuit de commande selon l'une quelconque des revendications précédentes,
**caractérisé en ce que**
le contrôleur de tension (140) présente un miroir de courant afin de refléter des modifications de courant à la suite de modifications dans la tension d'alimentation et d'alimenter un courant reflété entre le premier commutateur (110) et le premier raccord (101) afin d'entraîner l'adaptation de tension.

7. Circuit de commande selon l'une quelconque des revendications précédentes,
**caractérisé en ce que**
le détecteur de surintensité (130) présente ce qui suit :
- un premier détecteur de surintensité (131) pour la détection d'un premier courant entre le raccord d'alimentation (104) et le premier raccord (101) et/ou
- un second détecteur de surintensité (132) pour la détection d'un second courant entre le second raccord (102) et le raccord de masse (106).

8. Circuit de commande selon la revendication 7,
**caractérisé en ce que**
- le premier détecteur de surintensité (131) présente un premier filtre afin de filtrer des évènements de surintensité en dessous d'une première durée minimale fixe et d'ouvrir le premier commutateur (110) en cas de dépassement de la première période minimale fixe et/ou
- le second détecteur de surintensité (132) présente un second filtre afin de filtrer des évènements de surintensité en dessous d'une seconde durée minimale fixe et d'ouvrir le second commutateur (120) en cas de dépassement de la seconde période minimale fixe.

9. Circuit de commande selon l'une quelconque des revendications 2 ou 3 à 8, dans la mesure où elle se réfère à la revendication 2,
**caractérisé en ce que**
le premier détecteur de signal (210) et le second détecteur de signal (220) présentent respectivement un comparateur avec une entrée de tension de référence (+) et une entrée de signal de capteur (-), dans lequel l'entrée de tension de référence (+) du second détecteur de signal (220) est reliée au commutateur de rétrocouplage (230) afin de modifier une valeur de tension de référence au niveau du comparateur du second détecteur de signal (220) en réponse à une détection du signal de vitesse (12) par le premier détecteur de signal (210).

10. Circuit de commande selon la revendication 9,
dans lequel le circuit de surveillance (100) est un premier circuit de surveillance (100a) pour un premier capteur de vitesse de rotation et un second circuit de surveillance (100b) est configuré de manière identique au premier circuit de surveillance (100a) pour un second capteur de vitesse de rotation, et dans lequel le circuit de lecture (200) est un premier circuit de lecture (200a) et un second circuit de lecture (200b) est configuré de manière identique au premier circuit de lecture (200a),
**caractérisé en ce que**
les premiers détecteurs de signal respectifs sont configurés comme un premier comparateur à 4 canaux (210) et/ou
les seconds détecteurs de signal respectifs sont configurés comme un second comparateur à 4 canaux (220) et/ou
le premier détecteur de signal (210) et le second détecteur de signal (220) d'un circuit de lecture (200a, 200b) respectif sont configurés comme un comparateur à 4 canaux.

11. Circuit de commande selon la revendication 9 ou la revendication 10,
**caractérisé en ce que**
dans lequel le commutateur de rétrocouplage (230) comprend un circuit de transistor qui est configuré afin d'appliquer la valeur de tension de référence du comparateur du second détecteur de signal (220) à une valeur d'amplitude du signal de vitesse, de sorte que le second détecteur de signal (220) détecte toutes les impulsions si possible avec la même largeur d'impulsion.

12. Système antiblocage pour un véhicule utilitaire avec au moins un capteur de vitesse de rotation (10) actif,
**caractérisé par**
un appareil de commande avec au moins un circuit de commande selon l'une quelconque des revendications 1 à 11.

13. Procédé
**caractérisé par**
la commande et la surveillance d'un capteur de vitesse de rotation (10) actif d'un véhicule à l'aide d'un circuit de commande selon l'une quelconque des revendications 1 à 11.

14. Procédé selon la revendication 13 qui présente en outre au moins l'une des étapes suivantes pour la constatation d'un court-circuit et/ou d'une diaphonie :
- la saisie d'un premier signal sur le premier raccord de signal de statut (301),
- la saisie d'un second signal sur le second raccord de signal de statut (302),
- l'analyse d'un statut de signal sur le premier raccord de signal de statut (301),
- l'analyse d'un statut de signal sur le second raccord de signal de statut (302),
- la comparaison d'un statut de signal sur le premier raccord de signal de statut (301) et le second raccord de signal de statut (302).
